(19) Europäisches Patentamt / European Patent Office / Office européen des brevets

(11) **EP 3 566 229 B1**

(12) **EUROPEAN PATENT SPECIFICATION**

(45) Date of publication and mention
of the grant of the patent:
**25.11.2020   Bulletin 2020/48**

(21) Application number: **17701313.3**

(22) Date of filing: **23.01.2017**

(51) Int Cl.:
**G10L 21/0232** (2013.01)   **G10L 25/84** (2013.01)

(86) International application number:
**PCT/EP2017/051311**

(87) International publication number:
**WO 2018/133951 (26.07.2018 Gazette 2018/30)**

(54) **AN APPARATUS AND METHOD FOR ENHANCING A WANTED COMPONENT IN A SIGNAL**

VORRICHTUNG UND VERFAHREN ZUR VERBESSERUNG EINER ERWÜNSCHTEN KOMPONENTE IN EINEM SIGNAL

APPAREIL ET PROCÉDÉ PERMETTANT D'AMÉLIORER UNE COMPOSANTE SOUHAITÉE DANS UN SIGNAL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**13.11.2019   Bulletin 2019/46**

(73) Proprietor: **Huawei Technologies Co., Ltd.
Longgang District
Shenzhen, Guangdong 518129 (CN)**

(72) Inventors:
• **XIAO, Wei
80992 Munich (DE)**

• **JIN, Wenyu
80992 Munich (DE)**

(74) Representative: **Gill Jennings & Every LLP
The Broadgate Tower
20 Primrose Street
London EC2A 2ES (GB)**

(56) References cited:
**US-A1- 2003 023 430     US-A1- 2010 076 769
US-B1- 6 477 489**

**Description**

This invention relates to an apparatus and method for enhancing a signal that has a component that is wanted and a component that is unwanted.

It can be helpful to enhance a speech component in a noisy signal. For example, speech enhancement is desirable to improve the subjective quality of voice communication, e.g., over a telecommunications network. Another example is automatic speech recognition (ASR). If the use of ASR is to be extended, it needs to improve its robustness to noisy conditions. Some commercial ASR solutions claim to offer good performance, e.g., a word error rate (WER) of less than 10%. However, this performance is often only realisable under good conditions, with little noise. The WER can be larger than 40% under complex noise conditions.

One approach to enhance speech is to capture the audio signal with multiple microphones and filter those signals with an optimum filter. The optimum filter is typically an adaptive filter that is subject to certain constraints, such as maximising the signal-to-noise ratio (SNR). This technique is based primarily on noise control and gives little consideration to auditory perception. It is not robust under high noise levels. Too strong processing can also attenuate the speech component, resulting in poor ASR performance.

Another approach is based primarily on control of the foreground speech, as speech components tend to have distinctive features compared to noise. This approach increases the power difference between speech and noise using the so-called "masking effect". According to psychoacoustics, if the power difference between two signal components is large enough, the masker (with higher power) will mask the maskee (with lower power) so that the maskee is no longer audibly perceptible. The resulting signal is an enhanced signal with higher intelligibility.

A technique that makes use of the masking effect is Computational Auditory Scene Analysis (CASA). It works by detecting the speech component and the noise component in a signal and masking the noise component. One example of a specific CASA method is described in CN105096961. An overview is shown in Figure 1. In this technique, one of a set of multiple microphone signals is selected as a primary channel and processed to generate a target signal. This target signal is then used to define the constraint for an optimal filter to generate an enhanced speech signal. This technique makes use of a binary mask, which is generated by setting time and frequency bins in the primary signal's spectrum that are below a reference power to zero and bins above the reference power to one. This is a simple technique and, although CN105096961 proposes some additional processing, the target signal generated by this method generally has many spectrum holes. The additional processing also introduces some undesirable complexity into the technique, including the need for two time-frequency transforms and their inverses.

US 2003/023430 A1 describes a speech processing device comprising a speech-non-speech identifying section which determines a speech spectral signal as a speech portion including a speech component in the case where a difference between the speech spectral signal and a value of a noise base is not less than a predetermined threshold, while determining the signal as a non-speech portion including only a noise and no speech component in the other case. Based on the presence or absence of a speech component in each frequency bin, a comb filter generating section generates a comb filter for enhancing a speech pitch. An attenuation coefficient calculating section multiplies the comb filter by an attenuation coefficient based on frequency characteristics, sets an attenuation coefficient of an input signal for each frequency component, and outputs the attenuation coefficient of each frequency component to a multiplying section. The multiplying section multiplies a speech spectrum by the attenuation coefficient per frequency component basis. A frequency combining section combines spectra of frequency bin basis resulting from the multiplication to a speech spectrum continuous over a frequency region per predetermined unit time basis. It is an object of the invention to provide improved concepts for enhancing a wanted component in a signal.

The foregoing and other objects are achieved by the features of the independent claims. Further implementation forms are apparent from the dependent claims, the description and the figures.

According to a first, aspect as set forth in claim 1, a signal enhancer is provided that comprises an input configured to receive an audio signal that has a wanted component and an unwanted component. It also comprises a perception analyser that is configured to split the audio signal into a plurality of spectral components. The perception analyser is also configured to, for each spectral component, designate that spectral component as belonging to the wanted component or the unwanted component in dependence on a power estimate associated with that spectral component. If a spectral component is designated as belonging to the unwanted component, the perception analyser is configured to adjust its power by applying an adaptive gain to that spectral component, wherein the adaptive gain is selected in dependence on how perceptible the spectral component is expected to be to a user. This improves the intelligibility of the wanted component.

In the first aspect, the perceptual analyser is configured to, for each spectral component that is designated as belonging to the unwanted component, compare its power estimate with a power threshold. The perceptual analyser is configured to select the adaptive gain to be a gain that will leave the power associated with that spectral component unchanged if the power estimate is below the power threshold. The perceptual analyser is configured to select the adaptive gain to be a gain that will reduce the power associated with that spectral component if the power estimate is above the power threshold. This increases the relative power of the wanted component relative to the unwanted component, which improves the intelligibility of the wanted component.

In a first implementation form of the first aspect, the power threshold may be selected in dependence on a power at which that spectral component is expected to become perceptible to the user. This improves the intelligibility of the wanted component in a practical sense, since different frequency components are perceived differently by a human user.

In a second implementation form of the first aspect, the power threshold may be selected in dependence on how perceptible a spectral component is expected to be to a user given a power associated with one or more of the other spectral components. This improves the perceptibility of the wanted component in the enhanced signal.

In a third implementation form of the first aspect, the perception analyser may be configured to select the power threshold for each spectral component in dependence on a group associated with that spectral component, wherein the same power threshold is applied to the power estimates for all the spectral components comprised in a specific group. This is consistent with the principles of psychoacoustics.

In a fourth implementation form of the first aspect, the perception analyser may be configured to select the power threshold for each group of spectral components to be a predetermined threshold that is assigned to that specific group in dependence on one or more frequencies that are represented by the spectral components in that group. This is consistent with the principles of psychoacoustics.

In a fifth implementation form of the first aspect, the perception analyser may be configured to determine the power threshold for a group of spectral components in dependence on the power estimates for the spectral components in that specific group. This considers the relative strength, in the signal, of spectral components that are similarly perceptible to a human user.

In a sixth implementation form of the first aspect, the perception analyser may be configured to determine the power threshold for a specific group of spectral components by identifying the highest power estimated for a spectral component in that specific group and generating the power threshold by decrementing that highest power by a predetermined amount. This considers how perceptible a particular spectral component is likely to be given the power of other spectral components in its spectral group.

In an seventh implementation form of the first aspect, the perception analyser may be configured to select the power threshold for a group of spectral components by comparing a first threshold and a second threshold. The first threshold may be assigned to a specific group in dependence on one or more frequencies that are represented by the spectral components in that group. The second threshold may be determined in dependence on the power estimates for the spectral components in that group. The perception analyser may be configured to select, as the power threshold for the group, the lower of the first and second thresholds. The signal enhancer is thus able to select the more appropriate threshold.

In a eighth implementation form of the first aspect, the perception analyser may be configured to, for each spectral component that is designated as: (i) belonging to the unwanted component; and (ii) having a power estimate that is above the power threshold, select the adaptive gain to be a ratio between the power threshold and the power estimate for that spectral component. This reduces the power of the unwanted spectral component to an acceptable level.

In a ninth implementation form of the first aspect, the signal enhancer, in particular the signal enhancer of any of the above-mentioned implementation forms, comprises a transform unit. The transform unit may be configured to receive the audio signal in the time domain and convert that signal into the frequency domain, whereby the frequency domain version of the audio signal represents each spectral component of the audio signal by a respective coefficient. The perception analyser may be configured to adjust the power associated with a spectral component by applying the adaptive gain to the coefficient that represents that spectral component in the frequency domain version of the audio signal. Performing this adjustment in the frequency domain is convenient, because it is in the frequency domain that the perceptual differences between different parts of the audio signal become apparent.

In an tenth implementation form of the first aspect, the perception analyser may be configured to form a target audio signal to comprise non-adjusted coefficients, which represent the spectral components designated as belonging to the wanted component of the audio signal, and adjusted coefficients, which represent the spectral components designated as belonging to the unwanted component of the audio signal. This target audio signal can form a constraint for optimising the filtering of the audio signal and other audio signals. The target audio signal could be formed in the frequency domain or in the time domain.

In an eleventh implementation form of the first aspect, the transform unit of a signal enhancer may be configured to receive the target audio signal in the frequency domain convert it into the time domain, wherein the output is configured to output the time domain version of the target audio signal. This generates a time domain signal that can be used as a target audio signal.

According to a second aspect as set forth in claim 13, a method is provided that comprises obtaining an audio signal that has a wanted component and an unwanted component. The method comprises splitting the audio signal into a plurality of spectral components. It also comprises, for each spectral component, designating that spectral component as belonging to the wanted component or the unwanted component in dependence on a power estimate associated with that spectral component. The method comprises, if a spectral component is designated as belonging to the unwanted component, adjusting its power by applying an adaptive gain to that spectral component, wherein the adaptive gain is selected in dependence on how perceptible the spectral component is expected to be to a user.

According to a third aspect as set forth in claim 14, a non-transitory machine readable storage medium is provided having stored thereon processor executable instructions implementing a method. That method comprises obtaining an audio signal that has a wanted component and an unwanted component. It also comprises, for each spectral component, designating that spectral component as belonging to the wanted component or the unwanted component in dependence on a power estimate associated with that spectral component. The method comprises, if a spectral component is designated as belonging to the unwanted component, adjusting its power by applying an adaptive gain to that spectral component, wherein the adaptive gain is selected in dependence on how perceptible the spectral component is expected to be to a user.

The present invention will now be described by way of example with reference to the accompanying drawings. In the drawings:

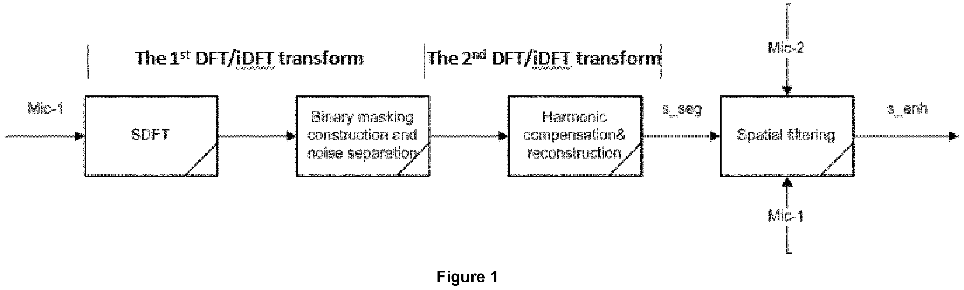

Figure 1 relates to a prior art technique for enhancing speech signals;

Figure 2 shows an example of a signal enhancer according to an embodiment of the invention;

Figure 3 shows an example of a process for enhancing a signal according to an embodiment of the invention;

Figure 4 shows a more detailed example of a process for enhancing a signal;

Figures 5a to c show processes for enhancing a signal according to embodiments in that use different final power thresholds for setting the adaptive gain;

Figure 6 shows absolute hearing thresholds for different bark bands;

Figure 7 shows how techniques according to one or more embodiments of the invention affect the relative power of wanted and unwanted signal components; and

Figures 8a and b show examples of speech processing systems that are configured to receive input signals from two microphones.

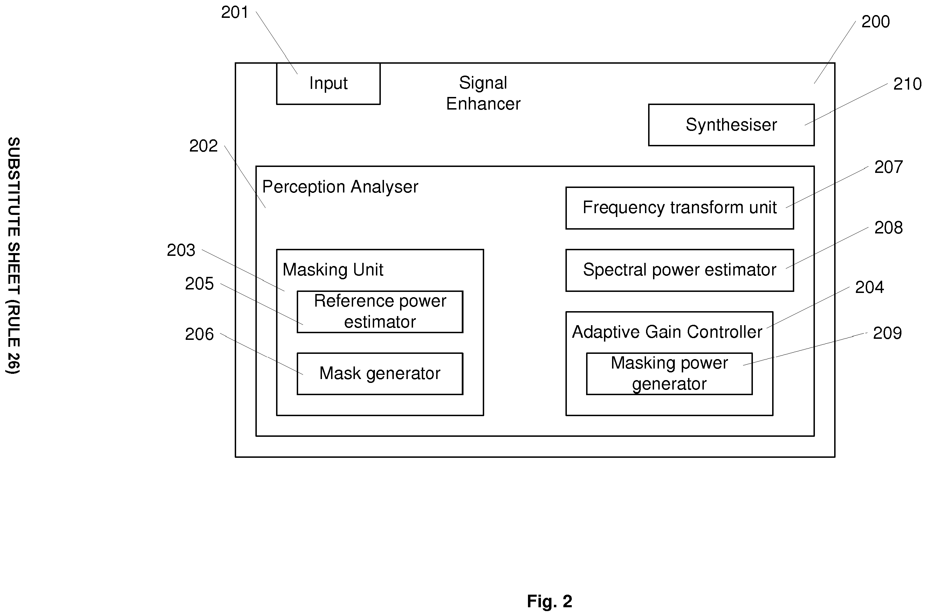

A signal enhancer is shown in Figure 2. The signal enhancer, shown generally at 200, comprises an input 201 and a perception analyser 202. The input is configured to receive a signal. The signal includes a component that is wanted and a component that is unwanted. In many embodiments, the signal will be an audio signal that represents sound captured by a microphone. The wanted component will usually be speech. The unwanted component will usually be noise. If a microphone is in an environment that includes speech and noise, it will typically capture an audio signal that is representative of both. The wanted and unwanted components are not limited to being speech or noise, however. They could be of any type of signal.

The perception analyser 202 comprises a frequency transform unit 207 that is configured to split the input signal into a plurality of spectral components. Each spectral component represents part of the input signal in a particular frequency band or bin. The perception analyser also includes a masking unit 203 that is configured to analyse each spectral component and designate it as being part of the wanted component or part of the unwanted component. The masking unit makes this decision in dependence on a power estimate that is associated with the spectral component. The perception analyser also includes an adaptive gain controller 204. If a spectral component is designated as being part of the unwanted component, the adaptive gain controller applies an adaptive gain to that spectral component. The adaptive gain is selected in dependence on how perceptible the spectral component is expected to be to a user.

The signal enhancer shown in Figure 2 also comprises a synthesiser 210. The synthesiser is an optional component that is configured to combine all spectral components together to form an enhanced signal, i.e. the synthesiser combines the wanted components and the adjusted unwanted components into a single output signal. The synthesiser may be configured to perform this operation in the frequency domain or in the time domain. For example, the spectral components may be converted into the time domain and then combined, or they may be combined in the frequency domain and then converted into the time domain.

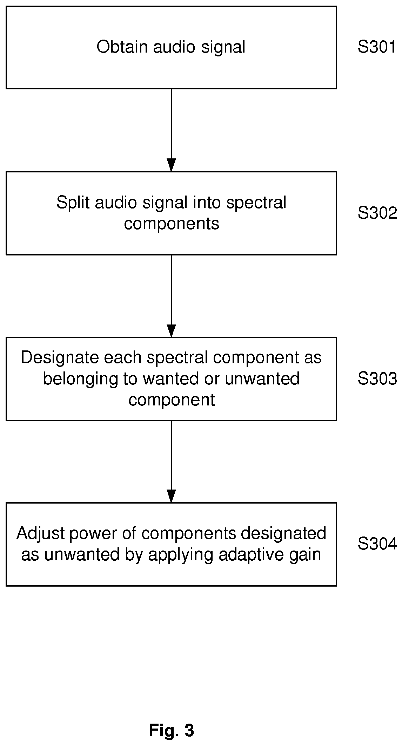

An example of a method for enhancing a signal is shown in Figure 3. The method starts in step S301 with obtaining an audio signal that has both a wanted component and an unwanted component. This signal is then split into a plurality of spectral components in step S302. Each spectral component is then designated either as belonging to the wanted component or as belonging to the unwanted component (step S303). This designation can be made in dependence on a power estimate that is associated with each spectral component. In step S304, the power of any components that have been designated as belonging to the unwanted component is adjusted by applying an adaptive gain to that spectral component. The adaptive gain is selected in dependence on how perceptible the spectral component is expected to be to a user.

The structures shown in Figure 2 (and all the block apparatus diagrams included herein) are intended to correspond to a number of functional blocks. This is for illustrative purposes only. Figure 2 is not intended to define a strict division between different parts of hardware on a chip or between different programs, procedures or functions in software. In some embodiments, some or all of the signal processing techniques described herein are likely to be performed wholly or partly in hardware. This particularly applies to techniques incorporating repetitive operations such as Fourier transforms and threshold comparisons. In some implementations, at least some of the functional blocks are likely to be implemented wholly or partly by a processor acting under software control. Any such software is suitably stored on a non-transitory machine readable storage medium. The processor could, for example, be a DSP of a mobile phone, smart phone, tablet or any generic user equipment or generic computing device.

The apparatus and method described herein can be used to implement speech enhancement in a system that uses signals from any number of microphones. In one example, the techniques described herein can be incorporated in a multi-channel microphone array speech enhancement system that uses spatial filtering to filter multiple inputs and to produce a single-channel, enhanced output signal. The enhanced signal that results from these techniques can provide a new constraint for spatial filtering by acting as a target signal. A signal that is intended to act as a target signal is preferably generated by taking account of psychoacoustic principles. This can be achieved by using an adaptive gain control that considers the estimated perceptual thresholds of different frequency components in the frequency domain.

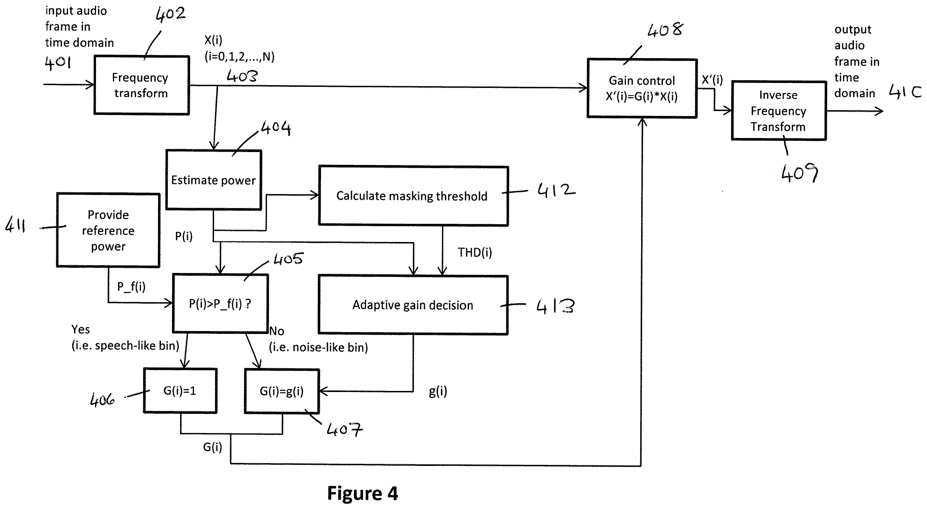

A more detailed embodiment is shown in Figure 4. This figure gives an overview of a speech enhancement technique that is described below with reference to some of the functional blocks shown in Figure 2. A frame of an audio signal 401 is input into the system in the time domain. For simplicity, Figure 4 and the description below describe the processing of a single frame. This input frame is processed by a frequency transform unit 207, 402 to output a series of frequency coefficients 403. Each frequency coefficient $X(i)$ represents the amplitude of spectral component in frequency bin i. The power associated with each of the spectral components is then estimated by spectral power estimator 208 using the coefficients 403. This estimated power is used by masking unit 203 to designate the respective spectral component either as belonging to noise and or as belonging to speech. Thus, some of the spectral components will be designated as belonging to noise and others of the spectral components as belonging to speech. In the example of Figure 4, this is done in 405 by the mask generator 206 comparing the estimated power for each spectral component with a reference power threshold 411 (which is generated by reference power estimator 205). The reference power threshold may be set to a power level that is dependent on a power expected of the noise components in the signal. Spectral components with a higher power than this are assumed to include speech. Spectral components with a lower power are assumed to just contain noise.

The spectral components that are designated as belonging to speech are then compared with a masking power threshold 412 (which is output by masking power generator 209). This additional power threshold $THD(i)$ relates to the power at which different spectral components are expected to become perceptible to a user. (There are various parameters that could be used to set this threshold, and some examples are described below.) The masking power threshold controls the adaptive gain decision 413 that is made by the adaptive gain controller 204. The gain $g(i)$ that is applied by the controller to the spectral component in bin i if that spectral component has been designated as noise changes in dependence on whether that spectral component meets the masking power threshold or not (in 407). In one example, the power of a spectral component is left unchanged if its power estimate is below the masking power threshold and is reduced if its power estimate is above the masking power threshold. Spectral components that have been designated as including speech are to be left unchanged, so a gain of one is selected for them in 406. This is just an example as any suitable gain could be applied. For example, in one example the spectral components that are designated as including speech could be amplified.

The gain selected for each spectral component is applied to each respective coefficient 408. The new coefficients $X'(i)$ form the basis for an inverse frequency transform 409 to construct an output frame in the time domain 410.

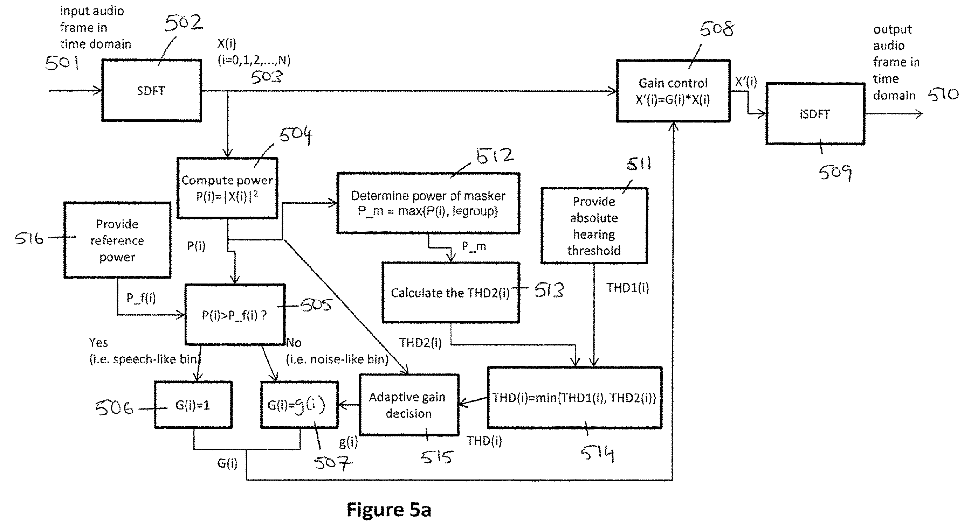

Figure 5a shows a similar process to that outlined in Figure 4. Figure 5a includes specific examples of how particular steps in the process could be performed. These specific examples could also be used for equivalent steps in processes that may differ from that shown in Figure 5a when considered overall. For example, Figure 5a illustrates an overall process in which the masking power threshold is selected from two options, THD1 and THD2. This does not mean that all the example steps described below are limited to embodiments in which the masking power threshold is selected from THD1 and THD2, however. For example, Figure 5a includes an example of how to estimate the power for each spectral component. This example is generally applicable, and could readily be incorporated within an overall process in which the masking threshold is selected in a different way from that shown in Figure 5a.

In Figure 5a the incoming signals are again processed in frames. This achieves real-time processing of the signals. Each incoming signal may be divided into a plurality of frames with a fixed frame length (e.g., 16 ms). The same processing is applied to all frames. The single channel input 501 may be termed "Mic-1". This input may be one of a set of microphone signals that all comprise a component that is wanted, such as speech, and a component that is unwanted, such as noise. The set of signals need not be audio signals and could be generated by methods other than being captured by a microphone.

In block 502 a time-frequency transform is performed on the audio signal received by the input to obtain its frequency spectrum. This step may be implemented by performing a Short-Time Discrete Fourier Transform (SDFT) algorithm. The SDFT is a Fourier-related transform used to determine the sinusoidal frequency and phase content of local sections of a signal as it changes over time. The SDFT may be computed by dividing the audio signal into short segments of equal length (such as a frame 501) and then computing the Fourier transform separately on each short segment. The result is the Fourier spectrum for each short segment of the audio signal, which captures the changing frequency spectra of the audio signal as a function of time. Each spectral component thus has an amplitude and a time extension.

An SDFT 502 is performed for each frame of the input signal 501. If the sampling rate is 16 kHz, the frame size might be set as 16ms. This is just an example and other sampling rates and frame sizes could be used. It should also be noted that there is no fixed relationship between sampling rate and frame size. So, for example, the sampling rate could be 48 kHz with a frame size of 16 ms. A 512-point SDFT can be implemented over the input signal. Performing the SDFT generates a series of complex-valued coefficients $X(i)$ in the frequency domain (where coefficient index i=0,1,2,3, etc. can be used to designate the index of the signal in the time domain or the index of coefficients in the frequency domain). These coefficients are Fourier coefficients and can also be referred to as spectral coefficients or frequency coefficients.

For each coefficient $X(i)$ a corresponding power $P(i) = |X(i)|^2$ is computed 503. This can be defined by:

$$P(i) = \text{real}(X(i))^2 + \text{imag}(X(i))^2$$

where real(*) and imag(*) are the real part and the imaginary part of the respective SDFT coefficient.

A reference power $P_f(i)$ is also estimated for each Fourier coefficient $X(i)$ 516. The perceptual analyser 202 in Figure 2 may incorporate a reference power estimator 205 for generating this estimate. Any suitable noise estimation (NE) method can be used for this estimation. A simple approach is to average the power density of each coefficient over the current frame and one or more previous frames. According to speech processing theory, this simple approach is most suitable for scenarios in which the audio signal is likely to incorporate stationary noise. Another option is to use advanced noise estimation methods, which tend to be suitable for scenarios incorporating non-stationary noise. In some embodiments, the reference power estimator may be configured to select an appropriate power estimation algorithm in dependence on an expected noise scenario, e.g., whether the noise is expected to be stationary or non-stationary in nature.

The next step is to implement binary masking by comparing the power $P(i)$ for each coefficient against the corresponding reference power $P_f(i)$ 505. This generates a binary masking matrix $M(i)$:

$$M(i) = \begin{cases} 1, if\ P(i) > \gamma . P_f(i) \\ 0, if\ P(i) \le \gamma . P_f(i) \end{cases}$$

where $\gamma$ is a pre-defined power spectral density factor.

The value $M(i) = 1$ in the binary mask indicates that the corresponding coefficient $P(i)$ is voice-like. In this case, there is no need to change the coefficient $P(i)$. The value $M(i) = 0$ indicates that the corresponding coefficient $P(i)$ is noise-like. In this case, the corresponding coefficient should be adjusted using adaptive gain control 506,507.

In the example of Figure 5a, adaptive gain control is composed of three operations.

In a first operation, an absolute hearing threshold (THD1) $Th1(i)$ (i=0,1,2,...) is provided for each frequency index (i=0,1,2,...) 511. This threshold is set in dependence on how perceptible each spectral component is expected to be to a user. Each frequency can be associated with a respective power threshold THD1, which is determined by psychoacoustic principles. Above the threshold, a spectral component at that frequency will be perceptible to the human auditory system; otherwise, it will not be perceptible. THD1 can thus be predefined and can be provided as a look-up table to masking power generator 209.

In practice, an absolute hearing threshold does not necessarily need to be defined for each individual spectral component. Instead the SDFT coefficients can be divided into several groups, and all coefficients within the same group can be associated with the same absolute hearing threshold. In other words, $Th1(i)=Th1(j)$ for any coefficient indices i, j that are part of the same respective group.

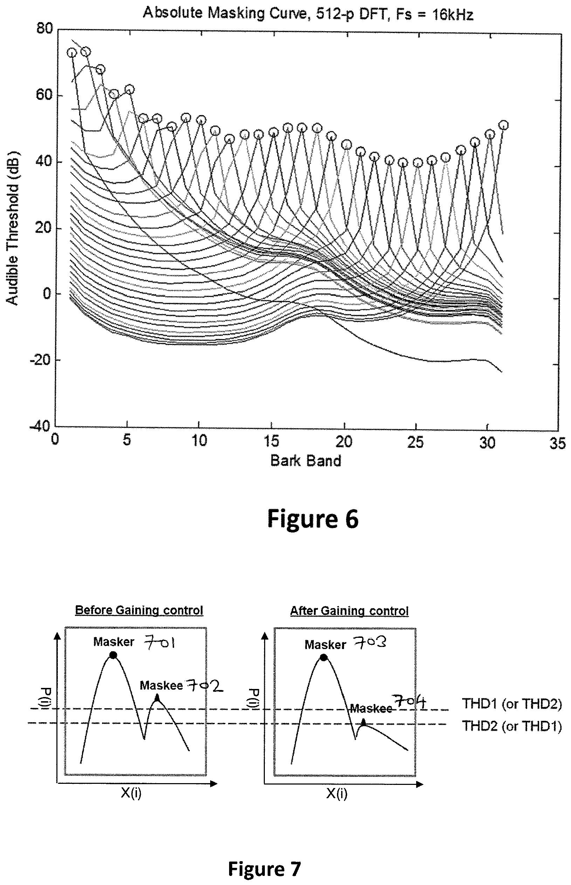

The set of SDFT coefficients is preferably divided into groups of coefficients that are adjacent to each other (i.e. the coefficients represent adjacent frequency bins and thus have adjacent indices). A simple approach is to uniformly divide the coefficients into N groups (e.g., N=30), where each group has the same number of SDFT coefficients. Alternatively, the groups may be concentrated at certain frequencies. The number of coefficients assigned to a particular group may be different for a low frequency group than for a high frequency group. A preferred approach is to use the so-called bark scale, which is similar to a log scale. This is consistent with the basics of psychoacoustics. In general, the number of coefficients in a low frequency group should be less than the number of coefficients in a high frequency group. The absolute hearing thresholds for different bark bands is shown in Figure 6, which assumes 31 bark bands and a 16 kHz sampling rate.

In a second operation, a relative masking threshold (THD2) is estimated for each frequency index (i=0,1, 2, ...) 513. THD2 can be set by considering the masking effect of different frequencies. THD2 is preferably not determined individually for each coefficient representing a frequency index i, but is instead determined for each group of frequency indices. The coefficients may be grouped together following any of the approaches described above. In each group, the coefficient that has the maximum power in the current group is set as the "masker" 512. THD2 may be set to the power of the masker minus some predetermined amount $\alpha$, where $\alpha$ may be set according to the principles of psychoacoustics. A suitable value for the predetermined amount $\alpha$ might be 13dB, for example.

The final masking threshold for each coefficient index is then selected to be the minimum of THD1 and THD2 514, i.e. THD(i) = min{THD1(i), THD2(i)}.

The third operation uses the binary mask determined in 505. For coefficients whose corresponding binary mask element is M(i)=1, the gain may be set to one, i.e. no change is made to that spectral component. For coefficients whose corresponding binary mask element is M(i)=0, the appropriate gain is determined by comparing the power determined for that spectral component in 504 with the threshold THD decided on in 514. This comparison is shown in block 515, and it can be expressed as follows:

$$g(i) = \begin{cases} 1, if\ P(i) < THD(i) \\ \dfrac{THD(i)}{P(i)}, if\ P(i) > THD(i) \end{cases}$$

where $g(i)$ is the adaptive gain.

Essentially, *if P(i) < THD(i)* the spectral component is too weak to be heard and gain control is not required. *If if P(i) > THD(i)* the spectral component is sufficiently strong to be heard and so its power is adjusted by applying an appropriate gain to its coefficient in the frequency domain. The adaptive gain control is applied in 508 by computing a new coefficient X'(i):

$$X'(i) = g(i) * X(i)$$

The new coefficients X'(i) (i=0,1,2,...) form the basis for the inverse Fourier transform in 509 that constructs the output frame 510. In this example the adjusted and non-adjusted coefficients are combined in the frequency domain and are then transformed together into the time domain. The combination could equally take place after the transformation into the time domain, so that the adjusted and non-adjusted coefficients are transformed into the time domain separately and then combined together to form a single output frame.

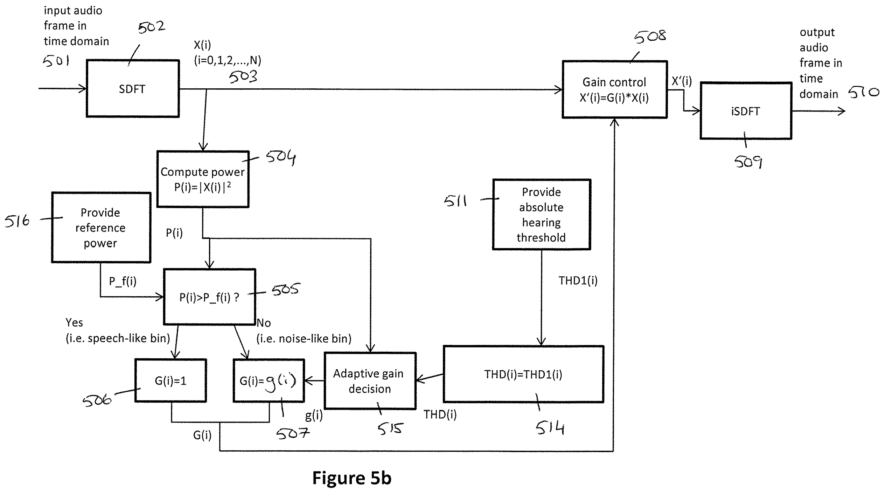

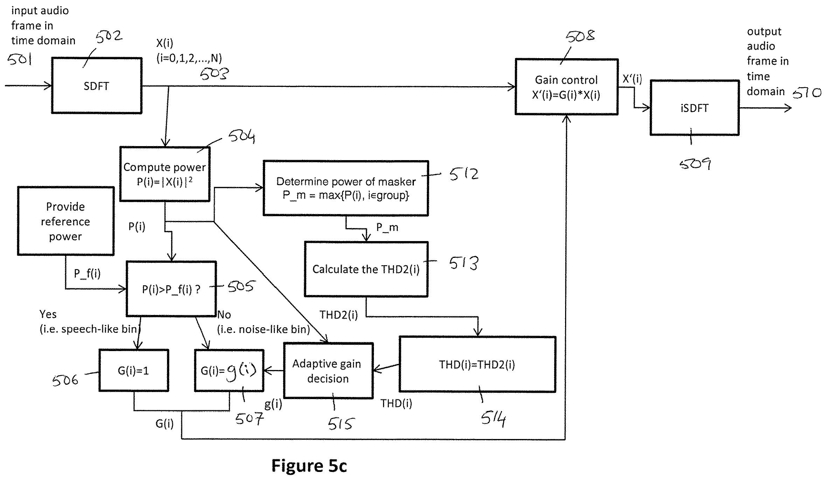

In other implementations, the threshold THD(i) may be determined differently. For example, Figure 5b shows an implementation in which the final threshold is set by the absolute threshold. In this example THD(i) = THD1(i) in 514 and it is unnecessary to calculate the relative masking threshold THD2. Another implementation is shown in Figure 5c. in this example, the final threshold is set by the relative threshold. Therefore, THD(i) = THD2(i) in 514 and it is unnecessary to calculate the absolute masking threshold THD1. In this implementation, it is desirable to increase the power difference between masker and maskee to obtain a better masking effect so the predetermined amount by which the power of the masker is decremented is preferably increased. For example, $\alpha$ may be increased from 13dB to 16dB.

The coefficient-wise gain control described above changes the frequency domain spectrum and masks the noise components so that they become less perceptible. This effect is illustrated in Figure 7. Masker 701 in the original signal (before gain control) belongs to a wanted component. Maskee 702 belongs to an unwanted component. After gain control, the power of masker 703 is unchanged, whereas the power of maskee 704 has been reduced (as demonstrated by the dashed lines). The relative power of the two components has thus been adjusted, with the effect that the wanted component has become more easily distinguishable over the unwanted component. This can be particularly useful in implementations where the input signal is a noisy speech signal, since the result is an enhanced signal with improved speech intelligibility. This enhanced signal can be used as a target signal in any multiple microphone speech enhancement technique.

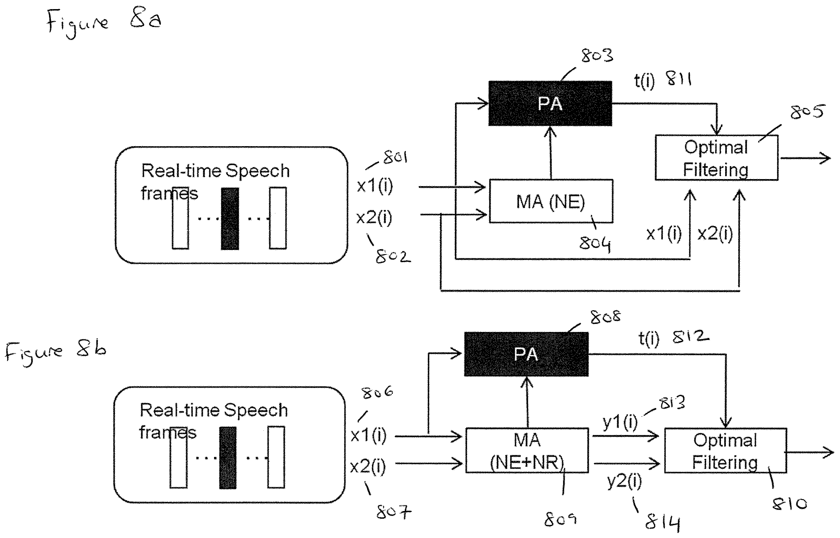

Figures 8a and b illustrate two examples of a system based on a multiple microphone array. In both these examples, the multiple microphone array has two microphones. This is solely for the purposes of example. It should be understood that the techniques described herein might be beneficially implemented in a system having any number of microphones, including systems based on single channel enhancement or systems having arrays with three or more microphones.

In Figures 8a and b, both systems are configured to receive real-time speech frames from two microphone signals: x1(i) and x2(i) (801, 802, 806, 807). Both systems have a perception analyser (PA) block 803, 808 that is configured to implement an enhancement technique in accordance with one or more of the embodiments described above. Each PA block outputs a target signal t(i) 811, 812. Each system also includes an optimal filtering block 805, 810. Each optimal filtering block is configured to implement an algorithm for filtering x1(i) and x2(i) subject to the constraint of the target signal t(i). any suitable algorithm might be used. For example, a generalized adaptive filtering algorithm could be based on the optimum filtering problem defined by:

$$\min(\left\|\widetilde{A} \cdot X - T\right\|^{2})$$

where X is a matrix expression of microphone signals x1(i) and x2(i) and T is a matrix expression of target signal t(i). The optimum filters parameters are defined by the matrix expression A˜. The set of optimum filter parameters A˜ can then be used to filter the microphone signals to generate a single, enhanced signal.

The primary aim in an ASR scenario is to increase the intelligibility of the audio signal that is input to the ASR block. The original microphone signals are optimally filtered. Preferably, no additional noise reduction is performed to avoid removing critical voice information. For a voice communication scenario, a good trade-off between subjective quality and intelligibility should be maintained. Noise reduction should be considered for this application. Therefore, the microphone signals may be subjected to noise reduction before being optimally filtered. These alternatives are illustrated in Figures 8a and b.

In Figure 8a, the primary function of the microphone array (MA) processing block 804 is noise estimation (NE). It is configured to generate the reference power density of each coefficient. The target signal t(i) is generated in the PA block 803. The optimal filtering block 805 completes the speech enhancement process by filtering the microphone signals constrained by target signal, t(i).

In Figure 8b, the primary function of MA block 809 is again noise estimation (NE). It is also configured to implement an appropriate noise reduction method (NR). This generates preliminary enhanced signals, y1(i) and y2(i) (813, 814). The target signal t(i) is generated in PA block 808. The optimal filtering block 810 completes the speech enhancement process by filtering the microphone signals constrained by target signal, t(i).

In the two-microphone arrangement shown in Figures 8a and b, either microphone signal can be used as the direct input to the PA blocks 803, 808. However, any other signal could also be used. For example, one of y1(i) and y2(i) can be used as the input to the PA block 803, 808. Another option is to deliberately pick a signal to achieve a particular effect. For example, a specific signal could be selected in order to implement beamforming, which aims to achieve further enhancements by considering the spatial correlation between different channels of microphone signals.

It should be understood that where this explanation and the accompanying claims refer to the device doing something by performing certain steps or procedures or by implementing particular techniques that does not preclude the device from performing other steps or procedures or implementing other techniques as part of the same process. In other words, where the device is described as doing something "by" certain specified means, the word "by" is meant in the sense of the device performing a process "comprising" the specified means rather than "consisting of" them.

The applicant hereby discloses in isolation each individual feature described herein and any combination of two or more such features, to the extent that such features or combinations are capable of being carried out based on the present specification as a whole in the light of the common general knowledge of a person skilled in the art, irrespective of whether such features or combinations of features solve any problems disclosed herein, and without limitation to the scope of the claims. The applicant indicates that aspects of the present invention may consist of any such individual feature or combination of features. In view of the foregoing description it will be evident to a person skilled in the art that various modifications may be made within the scope of the invention, which is defined by the claims.

## Claims

1. A signal enhancer (200) comprising:

    an input (201) configured to receive an audio signal that has a wanted component and an unwanted component;
    a perception analyser (202) configured to:

       split (S302) the audio signal into a plurality of spectral components;
       for each spectral component, designate (S303) that spectral component as belonging to the wanted component or the unwanted component in dependence on a power estimate associated with that spectral component; and
       if that spectral component is designated as belonging to the unwanted component, adjust (S304) its power by applying an adaptive gain to that spectral component, wherein the adaptive gain is selected in dependence on how perceptible the spectral component is expected to be to a user,

    characterized in that the perceptual analyser is configured to, for each spectral component that is designated as belonging to the unwanted component, compare its power estimate with a power threshold, and:

       if the power estimate is below the power threshold, select the adaptive gain to be a gain that will leave the power associated with that spectral component unchanged; and

if the power estimate is above the power threshold, select the adaptive gain to be a gain that will reduce the power associated with that spectral component.

2. A signal enhancer (200) as claimed in claim 1, wherein the power threshold is selected in dependence on a power at which that spectral component is expected to become perceptible to the user.

3. A signal enhancer (200) as claimed in claim 1 or 2, wherein the power threshold is selected in dependence on how perceptible a spectral component is expected to be to a user given a power associated with one or more of the other spectral components.

4. A signal enhancer (200) as claimed in any of claims 1 to 3, wherein the perception analyser (202) is configured to select the power threshold for each spectral component in dependence on a group associated with that spectral component, wherein the same power threshold is applied to the power estimates for all the spectral components comprised in a specific group.

5. A signal enhancer (200) as claimed in claim 4, wherein the perception analyser (202) is configured to select the power threshold for each group of spectral components to be a predetermined threshold that is assigned to that specific group in dependence on one or more frequencies that are represented by the spectral components in that group.

6. A signal enhancer (200) as claimed in claim 4 or 5, wherein the perception analyser (202) is configured to determine the power threshold for a group of spectral components in dependence on the power estimates for the spectral components in that specific group.

7. A signal enhancer (200) as claimed in claim 6, wherein the perception analyser (202) is configured to determine the power threshold for a specific group of spectral components by:

   identifying the highest power estimated for a spectral component in that specific group; and generating the power threshold by decrementing that highest power by a predetermined amount.

8. A signal enhancer (200) as claimed in any of claims 4 to 7, wherein the perception analyser (202) is configured to select the power threshold for a group of spectral components by comparing:

   a first threshold, which is assigned to that specific group in dependence on one or more frequencies that are represented by the spectral components in that group; and a second threshold, which is determined in dependence on the power estimates for the spectral components in that group; the perception analyser being configured to select, as the power threshold for the group, the lower of the first and second thresholds.

9. A signal enhancer (200) as claimed in any of claims 1 to 8, wherein the perception analyser (202) is configured to, for each spectral component that is designated as: (i) belonging to the unwanted component; and (ii) having a power estimate that is above the power threshold, select the adaptive gain to be a ratio between the power threshold and the power estimate for that spectral component.

10. A signal enhancer (200) as claimed in any preceding claim, wherein the signal enhancer comprises a transform unit (207) configured to:

    receive the audio signal in the time domain and convert that signal into the frequency domain, whereby the frequency domain version of the audio signal represents each spectral component of the audio signal by a respective coefficient; wherein the perception analyser (202) is configured to adjust the power associated with a spectral component by applying the adaptive gain to the coefficient that represents that spectral component in the frequency domain version of the audio signal.

11. A signal enhancer (200) as claimed in claim 10, wherein the perception analyser (202) is configured to form a target audio signal that comprises:

    non-adjusted coefficients that represent the spectral components designated as belonging to the wanted component of the audio signal; and adjusted coefficients that represent the spectral components designated as belonging to the unwanted component of the audio signal.

12. A signal enhancer (200) as claimed in claim 11, wherein the transform unit (207) is configured to receive the target audio signal in the frequency domain and convert it into the time domain, wherein an output of the signal enhancer is configured to output the time domain version of the target audio signal.

13. A method comprising:

    obtaining (S301) an audio signal that has a wanted component and an unwanted component;

splitting (S302) the audio signal into a plurality of spectral components;

for each spectral component, designating (S303) that spectral component as belonging to the wanted component or the unwanted component in dependence on a power estimate associated with that spectral component; and

if that spectral component is designated as belonging to the unwanted component, adjusting (S304) its power by applying an adaptive gain to that spectral component, wherein the adaptive gain is selected in dependence on how perceptible the spectral component is expected to be to a user,

**characterized in that** the adaptive gain is selected by, for each spectral component that is designated as belonging to the unwanted component, comparing its power estimate with a power threshold, and:

> if the power estimate is below the power threshold, selecting the adaptive gain to be a gain that will leave the power associated with that spectral component unchanged; and
> if the power estimate is above the power threshold, selecting the adaptive gain to be a gain that will reduce the power associated with that spectral component.

14. A non-transitory machine readable storage medium having stored thereon processor executable instructions implementing a method comprising:

> obtaining (S301) an audio signal that has a wanted component and an unwanted component;
> splitting (S302) the audio signal into a plurality of spectral components;
> for each spectral component, designating (S303) that spectral component as belonging to the wanted component or the unwanted component in dependence on a power estimate associated with that spectral component; and
> if that spectral component is designated as belonging to the unwanted component, adjusting (S304) its power by applying an adaptive gain to that spectral component, wherein the adaptive gain is selected in dependence on how perceptible the spectral component is expected to be to a user,
> **characterized in that** the adaptive gain is selected by, for each spectral component that is designated as belonging to the unwanted component, comparing its power estimate with a power threshold, and:
>
> > if the power estimate is below the power threshold, selecting the adaptive gain to be a gain that will leave the power associated with that spectral component unchanged; and

if the power estimate is above the power threshold, selecting the adaptive gain to be a gain that will reduce the power associated with that spectral component.

**Patentansprüche**

1. Signalenhancer (200), der Folgendes umfasst:

> einen Eingang (201), der konfiguriert ist, um ein Audiosignal zu empfangen, das eine erwünschte Komponente und eine unerwünschte Komponente aufweist;
> einen Wahrnehmungsanalysator (202), der für Folgendes konfiguriert ist:
>
> > Aufspalten (S302) des Audiosignals in mehrere Spektralkomponenten;
> > für jede Spektralkomponente, Bezeichnen (S303) dieser Spektralkomponente als zu der erwünschten Komponente oder der unerwünschten Komponente gehörend, in Abhängigkeit von einer mit dieser Spektralkomponente verknüpften Leistungsschätzung; und
> > falls diese Spektralkomponente als zu der unerwünschten Komponente gehörend bezeichnet wird, Einstellen (S304) ihrer Leistung durch Anwenden einer adaptiven Verstärkung auf diese Spektralkomponente, wobei die adaptive Verstärkung in Abhängigkeit davon ausgewählt wird, wie wahrnehmbar die Spektralkomponente für einen Benutzer erwartet wird,
> > **dadurch gekennzeichnet, dass** der Wahrnehmungsanalysator konfiguriert ist, um für jede Spektralkomponente, die als zu der unerwünschten Komponente gehörend bezeichnet wird, ihre Leistungsschätzung mit einem Leistungsschwellenwert zu vergleichen, und:
> >
> > > falls die Leistungsschätzung unter dem Leistungsschwellenwert liegt, Auswählen der adaptiven Verstärkung als eine Verstärkung, die die mit dieser Spektralkomponente verknüpfte Leistung unverändert lässt; und
> > > falls die Leistungsschätzung über dem Leistungsschwellenwert liegt, Auswählen der adaptiven Verstärkung als eine Verstärkung, die die mit dieser Spektralkomponente verknüpfte Leistung reduziert.

**2.** Signalenhancer (200) nach Anspruch 1, wobei der Leistungsschwellenwert in Abhängigkeit von einer Leistung ausgewählt wird, bei der erwartet wird, dass diese Spektralkomponente für den Benutzer wahrnehmbar wird.

**3.** Signalenhancer (200) nach Anspruch 1 oder 2, wobei der Leistungsschwellenwert in Abhängigkeit davon ausgewählt wird, wie wahrnehmbar eine Spektralkomponente für einen Benutzer bei einer Leistung erwartet wird, die mit einer oder mehreren der anderen Spektralkomponenten verknüpft ist.

**4.** Signalenhancer (200) nach einem der Ansprüche 1 bis 3, wobei der Wahrnehmungsanalysator (202) konfiguriert ist, um den Leistungsschwellenwert für jede Spektralkomponente in Abhängigkeit von einer Gruppe auszuwählen, die mit dieser Spektralkomponente verknüpft ist, wobei der gleiche Leistungsschwellenwert auf die Leistungsschätzungen für alle Spektralkomponenten angewendet wird, die in einer spezifischen Gruppe umfasst sind.

**5.** Signalenhancer (200) nach Anspruch 4, wobei der Wahrnehmungsanalysator (202) konfiguriert ist, um den Leistungsschwellenwert für jede Gruppe von Spektralkomponenten als einen zuvor bestimmten Schwellenwert auszuwählen, der dieser spezifischen Gruppe in Abhängigkeit von einer oder mehreren Frequenzen zugeordnet ist, die durch die Spektralkomponenten in dieser Gruppe dargestellt werden.

**6.** Signalenhancer (200) nach Anspruch 4 oder 5, wobei der Wahrnehmungsanalysator (202) konfiguriert ist, um den Leistungsschwellenwert für eine Gruppe von Spektralkomponenten in Abhängigkeit von den Leistungsschätzungen für die Spektralkomponenten in dieser spezifischen Gruppe zu bestimmen.

**7.** Signalenhancer (200) nach Anspruch 6, wobei der Wahrnehmungsanalysator (202) konfiguriert ist, um den Leistungsschwellenwert für eine spezifische Gruppe von Spektralkomponenten durch Folgendes zu bestimmen:

Identifizieren der höchsten Leistung, die für eine Spektralkomponente in dieser spezifischen Gruppe geschätzt wird; und
Erzeugen des Leistungsschwellenwertes durch Dekrementieren dieser höchsten Leistung um einen zuvor bestimmten Betrag.

**8.** Signalenhancer (200) nach einem der Ansprüche 4 bis 7, wobei der Wahrnehmungsanalysator (202) konfiguriert ist, um den Leistungsschwellenwert für eine Gruppe von Spektralkomponenten durch Vergleichen von Folgendem auszuwählen:

eines ersten Schwellenwertes, der dieser spezifischen Gruppe in Abhängigkeit von einer oder mehreren Frequenzen zugeordnet wird, die durch die Spektralkomponenten in dieser Gruppe dargestellt werden; und
eines zweiten Schwellenwertes, der in Abhängigkeit von den Leistungsschätzungen für die Spektralkomponenten in dieser Gruppe bestimmt wird;
wobei der Wahrnehmungsanalysator konfiguriert ist, um als Leistungsschwellenwert für die Gruppe den niedrigeren der ersten und zweiten Schwellenwerte auszuwählen.

**9.** Signalenhancer (200) nach einem der Ansprüche 1 bis 8, wobei der Wahrnehmungsanalysator (202) konfiguriert ist, um für jede Spektralkomponente, die als Folgendes bezeichnet ist: (i) zu der unerwünschten Komponente gehörend; und (ii) mit einer Leistungsschätzung, die über dem Leistungsschwellenwert liegt, die adaptive Verstärkung auswählt, um ein Verhältnis zwischen dem Leistungsschwellenwert und der Leistungsschätzung für diese Spektralkomponente zu bilden.

**10.** Signalenhancer (200) nach einem der vorhergehenden Ansprüche, wobei der Signalenhancer eine Transformationseinheit (207) umfasst, die für Folgendes konfiguriert ist:

Empfangen des Audiosignal in dem Zeitbereich und Umwandeln dieses Signal in den Frequenzbereich, wodurch die Frequenzbereichsversion des Audiosignals jede Spektralkomponente des Audiosignals durch einen jeweiligen Koeffizienten darstellt;
wobei der Wahrnehmungsanalysator (202) konfiguriert ist, um die mit einer Spektralkomponente verknüpfte Leistung durch Anwenden der adaptiven Verstärkung auf den Koeffizienten einzustellen, der diese Spektralkomponente in der Frequenzbereichsversion des Audiosignals darstellt.

**11.** Signalenhancer (200) nach Anspruch 10, wobei der Wahrnehmungsanalysator (202) konfiguriert ist, um ein Zielaudiosignal auszubilden, das Folgendes umfasst:

nicht angepasste Koeffizienten, die die Spektralkomponenten darstellen, die als zu der gewünschten Komponente des Audiosignals gehörend bezeichnet werden; und
angepasste Koeffizienten, die die Spektralkomponenten darstellen, die als zu der unerwünschten Komponente des Audiosignals gehörend bezeichnet werden.

**12.** Signalenhancer (200) nach Anspruch 11, wobei die Transformationseinheit (207) konfiguriert ist, um das Zielaudiosignal in dem Frequenzbereich zu empfangen und es in den Zeitbereich umzuwandeln, wobei ein Ausgang des Signalenhancers konfiguriert ist, um die Zeitbereichsversion des Zielaudiosignals auszugeben.

**13.** Verfahren, das Folgendes umfasst:

Erhalten (S301) eines Audiosignals, das eine erwünschte Komponente und eine unerwünschte Komponente aufweist;
Aufspalten (S302) des Audiosignals in mehrere Spektralkomponenten;
für jede Spektralkomponente, Bezeichnen (S303) dieser Spektralkomponente als zu der erwünschten Komponente oder der unerwünschten Komponente gehörend in Abhängigkeit von einer mit dieser Spektralkomponente verknüpften Leistungsschätzung; und
falls diese Spektralkomponente als zu der unerwünschten Komponente gehörend bezeichnet wird, Einstellen (S304) ihrer Leistung durch Anwenden einer adaptiven Verstärkung auf diese Spektralkomponente, wobei die adaptive Verstärkung in Abhängigkeit davon ausgewählt wird, wie wahrnehmbar die Spektralkomponente für einen Benutzer erwartet wird, **dadurch gekennzeichnet, dass** die adaptive Verstärkung durch Vergleichen ihrer Leistungsschätzung mit einem Leistungsschwellenwert für jede Spektralkomponente ausgewählt wird, die als zu der unerwünschten Komponente gehörend bezeichnet wird, und:

falls die Leistungsschätzung unter dem Leistungsschwellenwert liegt, Auswählen der adaptiven Verstärkung als eine Verstärkung, die die mit dieser Spektralkomponente verknüpfte Leistung unverändert lässt; und
falls die Leistungsschätzung über dem Leistungsschwellenwert liegt, Auswählen der adaptiven Verstärkung als eine Verstärkung, die die mit dieser Spektralkomponente verknüpfte Leistung reduziert.

**14.** Nichtflüchtiges maschinenlesbares Speichermedium mit darauf gespeicherten von einem Prozessor ausführbaren Anweisungen, die ein Verfahren implementieren, das Folgendes umfasst:

Erhalten (S301) eines Audiosignals, das eine erwünschte Komponente und eine unerwünschte Komponente aufweist;
Aufspalten (S302) des Audiosignals in mehrere Spektralkomponenten;

für jede Spektralkomponente, Bezeichnen (S303) dieser Spektralkomponente als zu der erwünschten Komponente oder der unerwünschten Komponente gehörend in Abhängigkeit von einer mit dieser Spektralkomponente verknüpften Leistungsschätzung; und
falls diese Spektralkomponente als zu der unerwünschten Komponente gehörend bezeichnet wird, Einstellen (S304) ihrer Leistung durch Anwenden einer adaptiven Verstärkung auf diese Spektralkomponente, wobei die adaptive Verstärkung in Abhängigkeit davon ausgewählt wird, wie wahrnehmbar die Spektralkomponente für einen Benutzer erwartet wird, **dadurch gekennzeichnet, dass** die adaptive Verstärkung durch Vergleichen ihrer Leistungsschätzung mit einem Leistungsschwellenwert für jede Spektralkomponente ausgewählt wird, die als zu der unerwünschten Komponente gehörend bezeichnet wird, und:

falls die Leistungsschätzung unter dem Leistungsschwellenwert liegt, Auswählen der adaptiven Verstärkung als eine Verstärkung, die die mit dieser Spektralkomponente verknüpfte Leistung unverändert lässt; und
falls die Leistungsschätzung über dem Leistungsschwellenwert liegt, Auswählen der adaptiven Verstärkung als eine Verstärkung, die die mit dieser Spektralkomponente verknüpfte Leistung reduziert.

## Revendications

**1.** Amplificateur de signal (200) comprenant :

une entrée (201) configurée pour recevoir un signal audio qui a une composante souhaitée et une composante non souhaitée ;
un analyseur de perception (202) configuré pour :

diviser (S302) le signal audio en une pluralité de composantes spectrales ;
pour chaque composante spectrale, désigner (S303) cette composante spectrale comme appartenant à la composante souhaitée ou à la composante non souhaitée en fonction d'une estimation de puissance associée à cette composante spectrale ; et si cette composante spectrale est désignée comme appartenant à la composante non souhaitée, ajuster (S304) sa puissance en appliquant un gain adaptatif à cette composante spectrale, le gain adaptatif étant sélectionné en fonction de la façon dont la composante spectrale doit être perceptible pour un utilisateur,

**caractérisé en ce que** l'analyseur perceptuel est configuré, pour chaque composante spectrale désignée comme appartenant à la composante non souhaitée, pour comparer son estimation de puissance à un seuil de puissance, et :

si l'estimation de puissance est inférieure au seuil de puissance, sélectionner le gain adaptatif comme étant un gain qui laissera la puissance associée à cette composante spectrale inchangée ; et
si l'estimation de puissance est supérieure au seuil de puissance, sélectionner le gain adaptatif comme étant un gain qui réduira la puissance associée à cette composante spectrale.

2. Amplificateur de signal (200) selon la revendication 1, dans lequel le seuil de puissance est sélectionné en fonction d'une puissance à laquelle cette composante spectrale doit devenir perceptible par l'utilisateur.

3. Amplificateur de signal (200) selon la revendication 1 ou 2, dans lequel le seuil de puissance est sélectionné en fonction de la façon dont une composante spectrale doit être perceptible pour un utilisateur étant donné une puissance associée à une ou plusieurs des autres composantes spectrales.

4. Amplificateur de signal (200) selon l'une quelconque des revendications 1 à 3, dans lequel l'analyseur de perception (202) est configuré pour sélectionner le seuil de puissance pour chaque composante spectrale en fonction d'un groupe associé à cette composante spectrale, dans lequel le même seuil de puissance est appliqué aux estimations de puissance pour toutes les composantes spectrales comprises dans un groupe spécifique.

5. Amplificateur de signal (200) selon la revendication 4, dans lequel l'analyseur de perception (202) est configuré pour sélectionner le seuil de puissance pour chaque groupe de composantes spectrales comme étant un seuil prédéterminé qui est attribué à ce groupe spécifique en fonction d'une ou de plusieurs fréquences représentées par les composantes spectrales dans ce groupe.

6. Amplificateur de signal (200) selon la revendication 4 ou 5, dans lequel l'analyseur de perception (202) est configuré pour déterminer le seuil de puissance pour un groupe de composantes spectrales en fonction des estimations de puissance pour les composantes spectrales dans ce groupe spécifique.

7. Amplificateur de signal (200) selon la revendication 6, dans lequel l'analyseur de perception (202) est configuré pour déterminer le seuil de puissance pour un groupe spécifique de composantes spectrales en :

identifiant la puissance la plus élevée estimée pour une composante spectrale dans ce groupe spécifique ; et
générant le seuil de puissance en décrémentant cette puissance la plus élevée par une quantité prédéterminée.

8. Amplificateur de signal (200) selon l'une quelconque des revendications 4 à 7, dans lequel l'analyseur de perception (202) est configuré pour sélectionner le seuil de puissance pour un groupe de composantes spectrales en comparant :

un premier seuil, qui est attribué à ce groupe spécifique en fonction d'une ou de plusieurs fréquences représentées par les composantes spectrales dans ce groupe ; et
un second seuil, qui est déterminé en fonction des estimations de puissance pour les composantes spectrales dans ce groupe ;
l'analyseur de perception étant configuré pour sélectionner, comme seuil de puissance pour le groupe, le plus bas des premier et second seuils.

9. Amplificateur de signal (200) selon l'une quelconque des revendications 1 à 8, dans lequel l'analyseur de perception (202) est configuré, pour chaque composante spectrale désignée comme : (i) appartenant à la composante non souhaitée ; et (ii) ayant une estimation de puissance qui est supérieure au seuil de puissance, pour sélectionner le gain adaptatif comme étant un rapport entre le seuil de puissance et l'estimation de puissance pour cette composante spectrale.

10. Amplificateur de signal (200) selon l'une quelconque des revendications précédentes, dans lequel l'amplificateur de signal comprend une unité de transformation (207) configurée pour :

recevoir le signal audio dans le domaine temporel et convertir ce signal dans le domaine de fréquence, grâce à quoi la version du domaine de fréquence du signal audio représente chaque composante spectrale du signal audio par un coefficient respectif ;
dans lequel l'analyseur de perception (202) est configuré pour ajuster la puissance associée à une composante spectrale en appliquant le gain adaptatif au coefficient qui représente cette composante spectrale dans la version du domaine de fréquence du signal audio.

**11.** Amplificateur de signal (200) selon la revendication 10, dans lequel l'analyseur de perception (202) est configuré pour former un signal audio cible qui comprend :

> des coefficients non ajustés qui représentent les composantes spectrales désignées comme appartenant à la composante souhaitée du signal audio ; et
> des coefficients ajustés qui représentent les composantes spectrales désignées comme appartenant à la composante non souhaitée du signal audio.

**12.** Amplificateur de signal (200) selon la revendication 11, dans lequel l'unité de transformation (207) est configurée pour recevoir le signal audio cible dans le domaine de fréquence et le convertir dans le domaine temporel, dans lequel une sortie de l'amplificateur de signal est configurée pour sortir la version du domaine temporel du signal audio cible.

**13.** Procédé comprenant :

> l'obtention (S301) d'un signal audio qui a une composante souhaitée et une composante non souhaitée ;
> la division (S302) du signal audio en une pluralité de composantes spectrales ;
> pour chaque composante spectrale, la désignation (S303) de cette composante spectrale comme appartenant à la composante souhaitée ou à la composante non souhaitée en fonction d'une estimation de puissance associée à cette composante spectrale ; et
> si cette composante spectrale est désignée comme appartenant à la composante non souhaitée, l'ajustement (S304) de sa puissance en appliquant un gain adaptatif à cette composante spectrale, le gain adaptatif étant sélectionné en fonction de la façon dont la composante spectrale doit être perceptible pour un utilisateur, **caractérisé en ce que** le gain adaptatif est sélectionné, pour chaque composante spectrale désignée comme appartenant à la composante non souhaitée, en comparant son estimation de puissance à un seuil de puissance, et :

>> si l'estimation de puissance est inférieure au seuil de puissance, en sélectionnant le gain adaptatif comme étant un gain qui laissera la puissance associée à cette composante spectrale inchangée ; et
>> si l'estimation de puissance est supérieure au seuil de puissance, en sélectionnant le gain adaptatif comme étant un gain qui réduira la puissance associée à cette composante spectrale.

**14.** Support de stockage lisible par machine non transitoire sur lequel sont stockées des instructions exécutables par processeur mettant en œuvre un procédé et comprenant :

> l'obtention (S301) d'un signal audio qui a une composante souhaitée et une composante non souhaitée ;
> la division (S302) du signal audio en une pluralité de composantes spectrales ;
> pour chaque composante spectrale, la désignation (S303) de cette composante spectrale comme appartenant à la composante souhaitée ou à la composante non souhaitée en fonction d'une estimation de puissance associée à cette composante spectrale ; et
> si cette composante spectrale est désignée comme appartenant à la composante non souhaitée, l'ajustement (S304) de sa puissance en appliquant un gain adaptatif à cette composante spectrale, le gain adaptatif étant sélectionné en fonction de la façon dont la composante spectrale doit être perceptible pour un utilisateur, **caractérisé en ce que** le gain adaptatif est sélectionné, pour chaque composante spectrale désignée comme appartenant à la composante non souhaitée, en comparant son estimation de puissance à un seuil de puissance, et :

>> si l'estimation de puissance est inférieure au seuil de puissance, en sélectionnant le gain adaptatif comme étant un gain qui laissera la puissance associée à cette composante spectrale inchangée ; et
>> si l'estimation de puissance est supérieure au seuil de puissance, en sélectionnant le gain adaptatif comme étant un gain qui réduira la puissance associée à cette composante spectrale.

The 1<sup>st</sup> DFT/iDFT transform  The 2<sup>nd</sup> DFT/iDFT transform

Mic-1 → **SDFT** → **Binary masking construction and noise separation** → **Harmonic compensation& reconstruction** → s_seg → **Spatial filtering** → s_enh

Mic-2

Mic-1

**Figure 1**

Fig. 2

```
┌─────────────────────────────────────┐
│                                     │
│         Obtain audio signal          │   S301
│                                     │
└─────────────────────────────────────┘
                    │
                    ▼
┌─────────────────────────────────────┐
│      Split audio signal into spectral │
│             components               │   S302
└─────────────────────────────────────┘
                    │
                    ▼
┌─────────────────────────────────────┐
│   Designate each spectral component as │
│      belonging to wanted or unwanted   │   S303
│              component               │
└─────────────────────────────────────┘
                    │
                    ▼
┌─────────────────────────────────────┐
│  Adjust power of components designated │
│   as unwanted by applying adaptive gain │   S304
└─────────────────────────────────────┘
```

**Fig. 3**

**Figure 4**

input audio frame in time domain

501

502

SDFT

X(i)
(i=0,1,2,...,N)
503

508

Gain control
X'(i)=G(i)*X(i)

X'(i)

output audio frame in time domain 510

iSDFT

509

504

Compute power
P(i)=|X(i)|²

512

Determine power of masker
P_m = max{P(i), i∈group}

P_m

511

Provide absolute hearing threshold

516

Provide reference power

P(i)

Calculate the THD2(i) 513

THD1(i)

P_f(i)

505

P(i)>P_f(i) ?

THD2(i)

Yes
(i.e. speech-like bin)

No
(i.e. noise-like bin)

506

G(i)=1

G(i)=g(i)

Adaptive gain decision

THD(i)=min{THD1(i), THD2(i)}

g(i)

THD(i)

514

507

515

G(i)

**Figure 5a**

**Figure 5b**

input audio
frame in
time domain  502
501

SDFT

X(i)
(i=0,1,2,...,N)
503

508
Gain control
X'(i)=G(i)*X(i)

X'(i)

output
audio
frame in
time
domain  510

iSDFT

509

504
Compute power
P(i)=|X(i)|²

Determine power of masker
P_m = max{P(i), i∈group}  512

P_m

Provide
reference
power

P(i)

Calculate the THD2(i)  513

P_f(i)

P(i)>P_f(i) ?  505

THD2(i)

Yes
(i.e. speech-like bin)

No
(i.e. noise-like bin)

506

G(i)=1

G(i)=g(i)

Adaptive gain
decision

THD(i)=THD2(i)

g(i)

507

515

THD(i)

514

G(i)

**Figure 5c**

Figure 6

Figure 7

Figure 8a

Figure 8b

**REFERENCES CITED IN THE DESCRIPTION**

**Patent documents cited in the description**

- CN 105096961
- US 2003023430 A1